# EUROPEAN PATENT SPECIFICATION

(11) **EP 4 152 611 B1**
(45) Date of publication and mention of the grant of the patent: **10.04.2024**
(21) Application number: 22191660.4
(22) Date of filing: 23.08.2022
(51) Int. Cl.: H03H 3/02, H03H 9/02, H03H 9/05, H03H 9/10, H03H 3/04

(54) **CRYSTAL OSCILLATOR, AND METHOD FOR MAKING THE SAME**
KRISTALLOSZILLATOR UND VERFAHREN ZU SEINER HERSTELLUNG
OSCILLATEUR À CRISTAL, ET SON PROCÉDÉ DE FABRICATION

(30) Priority: 31.08.2021 TW 110132309
(43) Date of publication of application: 22.03.2023
(73) Proprietor: National Yang Ming Chiao Tung University, Hsinchu City 30010 (TW); Aker Technoology Co., Ltd., Taichung City 42760 (TW)
(72) Inventor: HORNG, Ray-Hua, 40253 Taiwan (TW); LIN, Yi-Lun, 42760 Taiwan (TW)
(74) Representative: Sackin, Robert

(56) References cited:
- JP-A- 2015 080 007
- TW-B- 202 118 222
- US-A1- 2018 006 630

## Description

The disclosure relates to an oscillator and a method for making the same, and more particularly to a crystal oscillator having a high oscillation frequency, and a method for making the same.

A quartz crystal is a ceramic piezoelectric material, and is often used to make crystal oscillators with high oscillation frequencies, so that the quartz crystal is capable of being applied to various electronic products.

The conventional crystal oscillator generally includes an oscillation plate made of quartz crystal, and two electrodes that are respectively formed on two opposite surfaces of the oscillation plate and that are used for external electrical connection. The thinner the thickness of the oscillation plate, the higher the oscillation frequency of the crystal oscillator. Therefore, the oscillation plate is usually thinned by a thinning process in the industry, and thereby enabling the crystal oscillator to generate the desired oscillation frequency. In order to avoid poor strength in the thinned oscillation plate, which may break in the subsequent manufacturing process when subjected to external force, the oscillation plate is partially thinned, and after that, a thick frame that is made of a material that is the same as that of the oscillation plate, is formed and surrounds the thinned oscillation plate to increase the mechanical support of the thinned oscillation plate. Such a frame can be used as a pick-up portion, or can act as a connection region to connect to other electronic devices.

Japanese Invention Patent Application Publication No. JP2014154994A discloses an oscillation device in which a substrate of the oscillation device includes a flat oscillation portion, and a thick portion (e.g., a frame) that is integrally formed with the flat oscillation portion and that is used to increase the support of the oscillation device. By controlling the overall thickness of the substrate of the oscillation device, a predetermined oscillation frequency of the oscillation device can be attained.

However, since the crystal oscillator includes a thick frame, electrodes of the crystal oscillator are formed across the frame during the manufacturing process, resulting in a poor yield of the electrodes and adversely affecting the production quality of the crystal oscillator.

JP2015080007A discloses a crystal oscillator comprising an electrode portion on a side surface of the oscillating portion extending to outside of a support frame.

An object of the disclosure is to provide a crystal oscillator, and a method for making the same, which can alleviate or overcome the aforesaid shortcomings of the prior art.

According to a first aspect of the disclosure, a method for making a crystal oscillator includes the steps of:
a) forming a first electrode portion on a surface of a piezoelectric substrate, so as to obtain a semi-finished product;
b) thinning the piezoelectric substrate of the semi-finished product, so as to obtain an oscillating substrate, the oscillating substrate having a first surface on which the first electrode portion is formed;
c) forming a second electrode on a second surface of the oscillating substrate opposite to the first surface, the second electrode including a second electrode portion in positional correspondence with the first electrode portion, and a second extending electrode portion extending outwardly from the second electrode portion and disposed on a periphery area of the oscillating substrate;
d) forming a first extending electrode portion that extends from the first electrode portion along a side surface of the oscillating substrate to the second surface of the oscillating substrate, the first electrode portion and the first extending electrode portion cooperating to form a first electrode; and
e) forming a support frame on the second surface of the oscillating substrate, the support frame is made from a photoresist material and surrounding the second electrode portion, at least a portion of the second extending electrode portion is located outside the support frame.

According to a second aspect of the disclosure, a crystal oscillator includes an oscillating substrate, a first electrode, a second electrode, and a support frame.

The oscillating substrate has a first surface, a second surface opposite to the first surface, and a side surface interconnecting the first surface and the second surface.

The first electrode includes a first electrode portion disposed on the first surface of the oscillating substrate, and a first extending electrode portion extending from the first electrode portion on the first surface along the side surface to the second surface.

The second electrode is disposed on the second surface of the oscillating substrate, and includes a second electrode portion and a second extending electrode portion extending from the second electrode portion toward the first extending electrode portion on the second surface. A projection of the second electrode portion on the second surface of the oscillating substrate partially overlaps a projection of the first electrode portion on the second surface of the oscillating substrate. The second extending electrode portion and the first extending electrode portion are located at a same side of the oscillating substrate.

The support frame is made of a photoresist material, and is disposed on the second surface of the oscillating substrate. The support frame 5 surrounds the second electrode portion. At least a portion of the second extending electrode portion is located outside the support frame.

Other features and advantages of the disclosure will become apparent in the following detailed description of the embodiments with reference to the accompanying drawings, of which:
FIG. 1 is a schematic top view illustrating an embodiment of a crystal oscillator according to the disclosure;
FIG. 2 is a cross-sectional view taken along line II-II of FIG. 1;
FIG. 3 is a cross-sectional view taken along line III-III of FIG. 1;
FIG. 4 is a flow chart illustrating consecutive steps of a method for making the embodiment of the crystal oscillator according to the disclosure;
FIG. 5 is a schematic side view illustrating steps S81 to S85 of the embodiment of the method for making the embodiment of the crystal oscillator according to the disclosure; and
FIG. 6 is a schematic side view illustrating steps S86 to S88 of the embodiment of the method for making the embodiment of the crystal oscillator according to the disclosure.

Before the disclosure is described in greater detail, it should be noted that where considered appropriate, reference numerals or terminal portions of reference numerals have been repeated among the figures to indicate corresponding or analogous elements, which may optionally have similar characteristics.

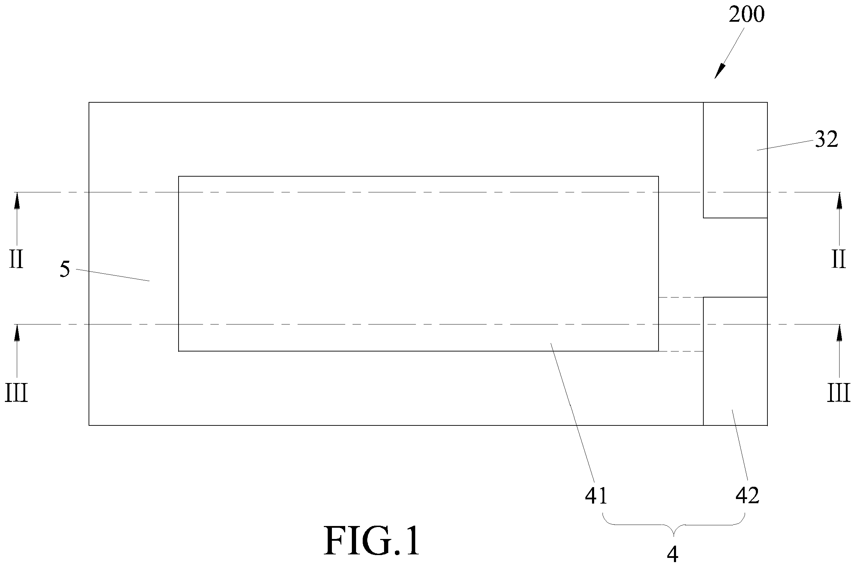

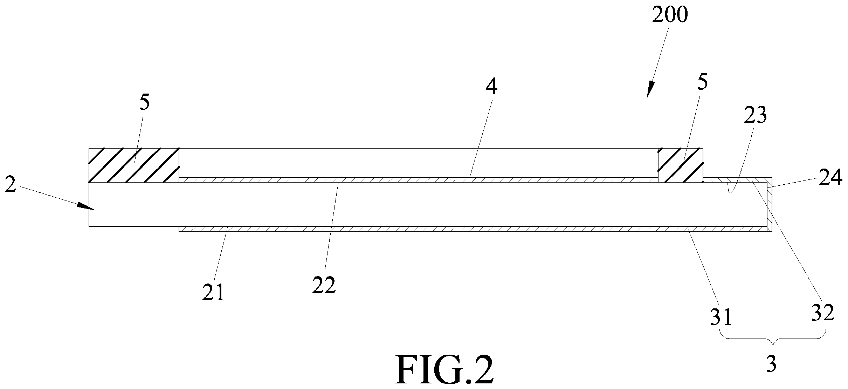

Referring to FIGS. 1 and 2, an embodiment of a crystal oscillator 200 according to the present disclosure includes an oscillating substrate 2, a first electrode 3, a second electrode 4, and a support frame 5.

The oscillating substrate 2 has a first surface 21, a second surface 22 opposite to the first surface 21, and a side surface 24 interconnecting the first surface 21 and the second surface 22. In this embodiment, the oscillating substrate 2 is made of quartz crystal, and has a thickness that is not greater than 50 um. In certain embodiments, the thickness of the oscillating substrate 2 is not greater than 10 um.

The first electrode 3 includes a first electrode portion 31 disposed on the first surface 21 of the oscillating substrate 2, and a first extending electrode portion 32 extending from the first electrode portion 31 on the first surface 21 along the side surface 24 to the second surface 22.

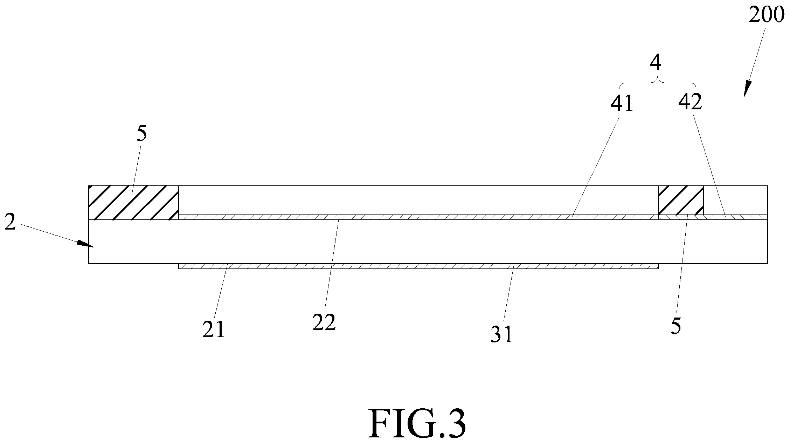

Referring to FIG. 3, the second electrode 4 is disposed on the second surface 22 of the oscillating substrate 2, and includes a second electrode portion 41 and a second extending electrode portion 42 extending from the second electrode portion 41 toward the first extending electrode portion 32 (not shown) on the second surface 22. A projection of the second electrode portion 41 on the second surface 22 of the oscillating substrate 2 partially overlaps a projection of the first electrode portion 31 on the second surface 22 of the oscillating substrate 2. The second extending electrode portion 42 and the first extending electrode portion 32 are spaced apart from each other and are located at a same side of the oscillating substrate 2.

Each of the first electrode 3 and the second electrode 4 is independently made from gold, silver, aluminum, or combinations thereof. The first electrode 3 and the second electrode 4 may be made of the same or different materials.

The support frame 5 is made of a photoresist material, and is disposed on the second surface 22 of the oscillating substrate 2. In certain embodiments, the photoresist material may be one of a positive photoresist and a negative photoresist. In certain embodiments, the support frame 5 may have a thickness ranging from 10 um to 100 um.

In this embodiment, the support frame 5 surrounds the second electrode portion 41, and at least a portion of the second extending electrode portion 42 is located outside the support frame 5. The second surface 22 of the oscillating substrate 2 includes at least one peripheral area 23 that is located outside and exposed from the support frame 5 (see FIG. 2). The first extending electrode portion 32 and the second extending electrode portion 42 are located on the at least one peripheral area 23. Specifically, the second extending electrode portion 42 extends from the second electrode portion 41, passes through a region defined between the support frame 5 and the oscillating substrate 2 and terminates at the at least one peripheral area 23, and the first extending electrode portion 32 extends from the first electrode portion 31 on the first surface 21 onto the at least one peripheral area 23. The first extending electrode portion 32 and the second extending electrode portion 42 are formed on the second surface 22, which is conducive for external electrical connection, and which facilitates the disposing of the crystal oscillator 200 in electronic products in subsequent applications.

In this embodiment, the support frame 5 is formed as a ring structure. There are no particular limitations on the width, shape, and location of the support frame 5, as long as the support frame 5 can be used to increase the thickness of the crystal oscillator 200, and provides a pick-up position. For example, the support frame 5 may include at least two strip structures which are located at two sides (e.g., two opposite sides) of the oscillating substrate 2. For another example, the support frame 5 may be formed as an interrupted ring structure.

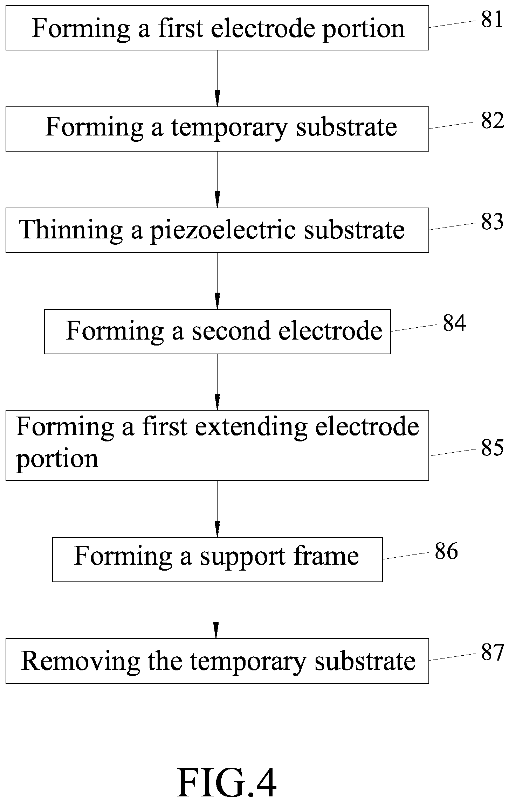

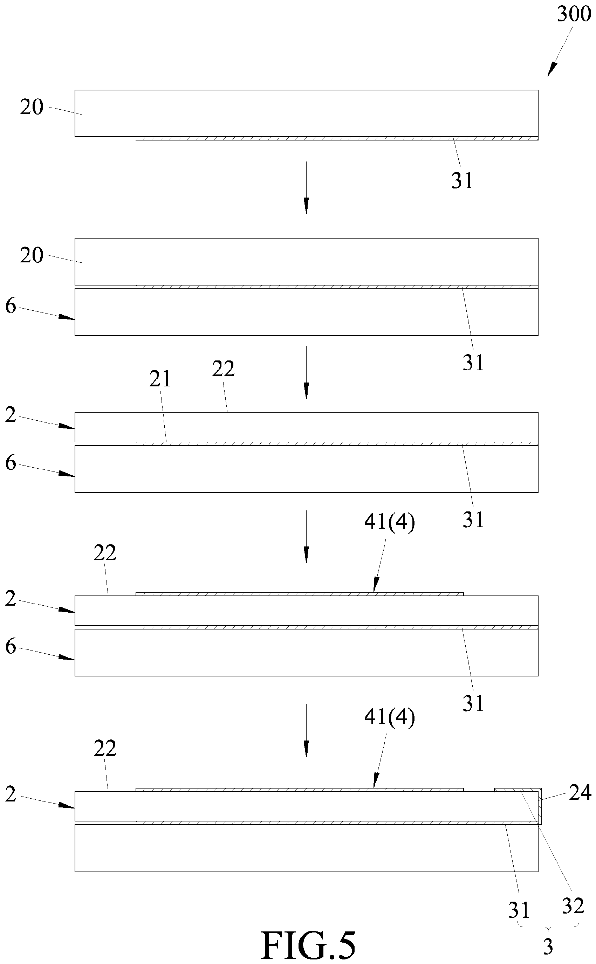

Referring to FIGS. 4 to 6, this disclosure also provides a method for making the embodiment of the crystal oscillator 200, which includes the following steps S81 to S88.

In step S81, the first electrode portion 31 is formed on a surface of a piezoelectric substrate 20 made of quartz, so as to obtain a semi-finished product 300. The first electrode portion 31 is formed by depositing or printing a conductive material on the surface of the piezoelectric substrate 20.

In step S82, the semi-finished product 300 is attached to a temporary substrate 6 with the first electrode portion 31 facing the temporary substrate 6. The temporary substrate 6 may be made of glass, acrylic or ceramic, and is used to support the piezoelectric substrate 20, so as to prevent the piezoelectric substrate 20 from breaking due to poor mechanical strength in the subsequent process (e.g., step S83) .

In step S83, the piezoelectric substrate 20 of the semi-finished product 300 is thinned by a polishing process or chemical etching process, so as to obtain the oscillating substrate 2 having the first surface 21 on which the first electrode portion 31 is formed. It is noted that the thickness of the oscillating substrate 2 may vary depending on the desired oscillation frequency, and the oscillating substrate 2 may have a uniform thickness. In certain embodiments, the thickness of the oscillating substrate 2 is not larger than 50 um. In certain embodiments, when the crystal oscillator 200 is a high frequency oscillator, the thickness of the oscillating substrate 2 may not be larger than 10 um.

In step S84, the second electrode 4 is formed on the second surface 22 of the oscillating substrate 2. The second electrode 4 includes the second electrode portion 41 in positional correspondence with the first electrode portion 31, and the second extending electrode portion 42 (see FIGS. 1 and 3) extending outwardly from the second electrode portion 41 and disposed on a periphery area of the oscillating substrate 2. The second electrode 4 is formed by depositing or printing a conductive material on the second surface 22 of the oscillating substrate 2.

In step S85, the first extending electrode portion 32 extends from the first electrode portion 31 along the side surface 24 of the oscillating substrate 2 to the second surface 22 of the oscillating substrate 2. The first electrode portion 31 and the first extending electrode portion 32 cooperates to form the first electrode 3. The first extending electrode portion 32 is formed by printing or depositing a conductive material on the side surface 24 and the second surface 22 of the oscillating substrate 2. The first extending electrode portion 32 and the second extending electrode portion 42 are disposed on the second surface 22 of the oscillating substrate 2.

In certain embodiments, step S85 may be conducted by forming a portion of the first extending electrode portion 32 on the second surface 22 of the oscillating substrate 2, followed by forming a conductive material (e.g., a silver paste) on the side surface 24 to interconnect the first electrode portion 31 and the portion of the first extending electrode portion 32 on the second surface 22 of the oscillating substrate 2. In this embodiment, the conductive material and the portion of the first extending electrode portion 32 constitute the first extending electrode portion 32.

It is noted that, according to processing requirements, step S85 may be conducted after step S83 and before step S84.

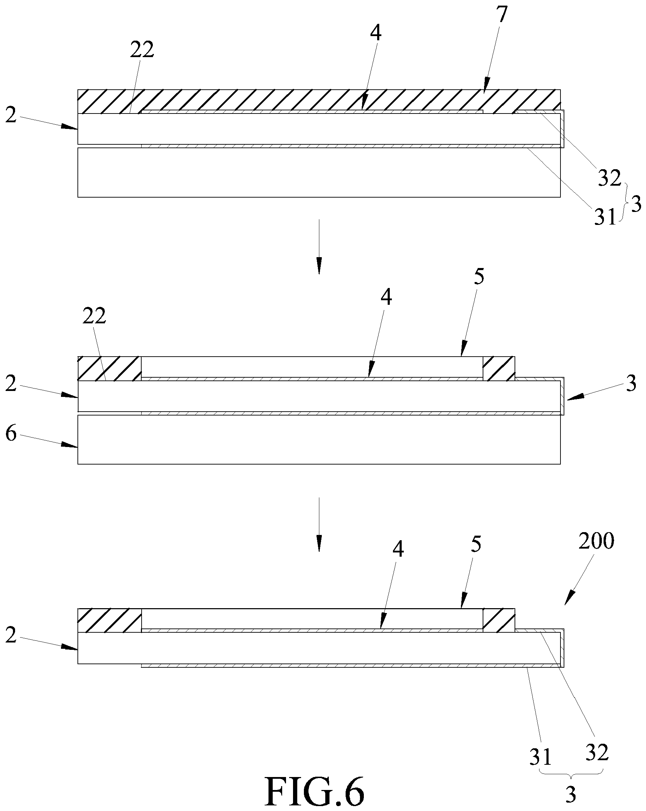

In step S86, the support frame 5 is formed on the second surface 22 of the oscillating substrate 2. Step S86 may include (i) coating a photoresist layer 7 (e.g., a positive photoresist or a negative photoresist) having a predetermined thickness on the second surface 22 (see FIG. 6), and then (ii) removing a portion of the photoresist layer 7 by photolithography process, so as to form the support frame 5 into a predetermined shape on the second surface 22 of the oscillating substrate 2.

To be specific, by adjusting the parameters of the coating process and the patterned mask used in the photolithography process, the thickness, width, shape, and location of the support frame 5 can be precisely controlled to meet the design requirements. It is noted that the details and parameters of the coating and photolithography processes (e.g., the thickness of the photoresist layer 7, exposure wavelength, exposure intensity, or exposure time), or a method for forming the patterned mask may vary depending on the material for the photoresist layer 7). The coating and photolithography processes are known to those skilled in the art, and therefore are omitted for the sake of brevity.

In step S87, the temporary substrate 6 is removed from the first electrode portion 31 on the first surface 21 of the oscillating substrate 2. Procedure for implementing step S87 may be chosen according to the procedure for attaching the temporary substrate 6 on the first electrode portion 31 in step S82. For example, when step S82 is conducted using a photosensitive adhesive or a thermo-sensitive adhesive, step S87 may be conducted using light radiation or heat application so as to decompose the photosensitive adhesive or the thermo-sensitive adhesive, thereby removing the temporary substrate 6 from the first electrode portion 31.

In sum, by use of the photoresist layer 7 to form the support frame 5, the thickness, width, shape, and location of the support frame 5 can be precisely controlled through adjusting the parameters of the coating process and the patterned mask of the photolithography process, so that the thickness of the crystal oscillator 200 (i.e., the thickness of the oscillating substrate 2 and the thickness of the support frame 5) can be further controlled, which enables the crystal oscillator 200 to have the expected oscillation frequency.

In the description above, for the purposes of explanation, numerous specific details have been set forth in order to provide a thorough understanding of the embodiment. It will be apparent, however, to one skilled in the art, that one or more other embodiments may be practiced without some of these specific details, any embodiment having the features according to the appended claims.

It should also be appreciated that reference throughout this specification to "one embodiment," "an embodiment," an embodiment with an indication of an ordinal number and so forth means that a particular feature, structure, or characteristic may be included in the practice of the disclosure, any embodiment having the features according to the appended claims.

It should be further appreciated that in the description, various features are sometimes grouped together in a single embodiment, figure, or description thereof for the purpose of streamlining the disclosure and aiding in the understanding of various inventive aspects, and that one or more features or specific details from one embodiment may be practiced together with one or more features or specific details from another embodiment, where appropriate, in the practice of the disclosure, any embodiment having the features according to the appended claims.

## Claims

1. A method for making a crystal oscillator (200), comprising the steps of:
a) forming a first electrode portion (31) on a surface of a piezoelectric substrate (20), so as to obtain a semi-finished product (300);
b) thinning the piezoelectric substrate (20) of the semi-finished product (300), so as to obtain an oscillating substrate (2), the oscillating substrate having a first surface (21) on which the first electrode portion (31) is formed;
c) forming a second electrode (4) on a second surface (22) of the oscillating substrate (2) opposite to the first surface (21), the second electrode (4) including a second electrode portion (41) in positional correspondence with the first electrode portion (31), and a second extending electrode portion (42) extending outwardly from the second electrode portion (41) and disposed on a periphery area of the oscillating substrate (2);
d) forming a first extending electrode portion (32) that extends from the first electrode portion (31) along a side surface (24) of the oscillating substrate (2) to the second surface (22) of the oscillating substrate (2), the first electrode portion (31) and the first extending electrode portion (32) cooperating to form a first electrode (3); **characterised by**
e) forming a support frame (5) on the second surface (22) of the oscillating substrate (2), the support frame (5) made from a photoresist material and surrounding the second electrode portion (41), at least a portion of the second extending electrode portion (42) being located outside the support frame (5) .

2. The method of claim 1, further **characterized in that**, after step a) and before step b), attaching the semi-finished product (300) on a temporary substrate (6) with the first electrode portion (31) facing the temporary substrate (6).

3. The method of claim 2, further **characterized in that**, after step e), removing the temporary substrate (6) from the first electrode portion (31) on the first surface (21) of the oscillating substrate (2).

4. The method of any one of claims 1 to 3, **characterized in that** the photoresist material is one of a positive photoresist and a negative photoresist.

5. The method of any one of claims 1 to 4, **characterized in that** each of the first electrode portion (31) and the second electrode (4) is made from a conductive material, and the steps a) and c) are conducted by one of deposition process and printing process.

6. The method of any one of claims 1 to 5, **characterized in that** the first extending electrode portion (32) is made from a conductive material, and step d) is conducted by one of printing process and deposition process.

7. The method of any one of claims 1 to 6, **characterized in that** each of the first electrode portion (31), the first extending electrode portion (32), and the second electrode (4) is independently made from gold, silver, aluminum, or combinations thereof.

8. The method of any one of claims 1 to 7, **characterized in that** the first electrode portion (31), the first extending electrode portion (32), and the second electrode (4) are made from different materials.

9. A crystal oscillator (200), comprising:
an oscillating substrate (2) having a first surface (21), a second surface (22) opposite to said first surface (21), and a side surface (24) interconnecting said first surface (21) and said second surface (22);
a first electrode (3) including a first electrode portion (31) disposed on said first surface (21) of said oscillating substrate (2), and a first extending electrode portion (32) extending from said first electrode portion (31) on said first surface (21) along said side surface (24) to said second surface (22);
a second electrode (4) disposed on said second surface (22) of said oscillating substrate (2), and including a second electrode portion (41) and a second extending electrode portion (42) extending from said second electrode portion (41) toward said first extending electrode portion (32) on said second surface (22), a projection of said second electrode portion (41) on said second surface (22) of said oscillating substrate (2) partially overlapping a projection of said first electrode portion (31) on said second surface (22) of said oscillating substrate (2), said second extending electrode portion (42) and said first extending electrode portion (32) being located at a same side of said oscillating substrate (2); **characterised by**
a support frame (5) made of a photoresist material and disposed on said second surface (22) of said oscillating substrate (2), said support frame (5) surrounding said second electrode portion (41), at least a portion of said second extending electrode portion (42) located outside said support frame (5).

10. The crystal oscillator (200) of claim 9, **characterized in that** said support frame (5) has a thickness ranging from 10 um to 100 µm.

11. The crystal oscillator (200) of claim 9 or 10, **characterized in that** said second surface (22) of said oscillating substrate (2) includes at least one peripheral area (23) that is located outside and exposed from said support frame (5), said first extending electrode portion (32) and said second extending electrode portion (42) located on said at least one peripheral area (23).

12. The crystal oscillator (200) of any one of claims 9 to 11, **characterized in that** said support frame (5) is formed as a ring structure, said second extending electrode portion (42) extending from said second electrode portion (41), passing through a region defined between said support frame (5) and said oscillating substrate (2), and terminating at said at least one peripheral area (23).

## Patentansprüche

1. Verfahren zur Herstellung eines Kristalloszillators (200), das die folgenden Schritte aufweist:
a) Bilden eines ersten Elektrodenteils (31) auf einer Oberfläche eines piezoelektrischen Substrats (20), um ein Halbzeug (300) zu erhalten;
b) Ausdünnen des piezoelektrischen Substrats (20) des Halbzeugs (300), um ein schwingendes Substrat (2) zu erhalten, wobei das schwingende Substrat eine erste Oberfläche (21) aufweist, auf der das erste Elektrodenteil (31) gebildet ist;
c) Bilden einer zweiten Elektrode (4) auf einer zweiten Oberfläche (22) des schwingenden Substrats (2), die der ersten Oberfläche (21) entgegengesetzt ist, wobei die zweite Elektrode (4) einen zweiten Elektrodenteil (41) in positioneller Übereinstimmung mit dem ersten Elektrodenteil (31) und einen zweiten sich erstreckenden Elektrodenteil (42), der sich auswärts des zweiten Elektrodenteils (41) erstreckt und an einem Randbereich des schwingenden Substrats (2) angeordnet ist, beinhaltet;
d) Bilden eines ersten sich erstreckenden Elektrodenteils (32), der sich von dem ersten Elektrodenteil (31) an einer Seitenfläche (24) des schwingenden Substrats (2) entlang zur zweiten Oberfläche (22) des schwingenden Substrats (2) erstreckt, wobei der erste Elektrodenteil (31) und der erste sich erstreckende Elektrodenteil (32) zusammenwirkend eine erste Elektrode bilden; **gekennzeichnet durch**
e) Bilden eines tragenden Rahmens (5) auf der zweiten Oberfläche (22) des schwingenden Substrats (2), wobei der tragende Rahmen (5) aus einem Fotolackmaterial hergestellt ist und den zweiten Elektrodenteil (41) umgibt, wobei wenigstens ein Teil des zweiten sich erstreckenden Elektrodenteils (42) außerhalb des tragenden Rahmens (5) liegt.

2. Verfahren nach Anspruch 1, ferner **gekennzeichnet durch**, nach Schritt a) und vor Schritt b), Anbringen des Halbzeugs (300) auf einem provisorischen Substrat (6), wobei der erste Elektrodenteil (31) dem provisorischen Substrat (6) gegenüberliegt.

3. Verfahren nach Anspruch 2, das ferner **gekennzeichnet ist durch**, nach Schritt e), Entfernen des provisorischen Substrats (6) von dem ersten Elektrodenteil (31) auf der ersten Oberfläche (21) des schwingenden Substrats (2).

4. Verfahren nach einem der Ansprüche 1 bis 3, **dadurch gekennzeichnet, dass** das Fotolackmaterial einer von einem Positivfotolack und einem Negativfotolack ist.

5. Verfahren nach einem der Ansprüche 1 bis 4, **dadurch gekennzeichnet, dass** der erste Elektrodenteil (31) und die zweite Elektrode (4) jeweils aus einem leitfähigen Material hergestellt werden und die Schritte a) und c) von einem von dem Aufbringungsprozess und dem Druckprozess durchgeführt werden.

6. Verfahren nach einem der Ansprüche 1 bis 5, **dadurch gekennzeichnet, dass** der erste sich erstreckende Elektrodenteil (32) aus einem leitfähigen Material hergestellt ist und Schritt d) von einem von dem Druckprozess und dem Aufbringungsprozess durchgeführt wird.

7. Verfahren nach einem der Ansprüche 1 bis 6, **dadurch gekennzeichnet, dass** der erste Elektrodenteil (31), der erste sich erstreckende Elektrodenteil (32) und die zweite Elektrode (4) jeweils unabhängig aus Gold, Silber, Aluminium oder Kombinationen davon hergestellt sind.

8. Verfahren nach einem der Ansprüche 1 bis 7, **dadurch gekennzeichnet, dass** der erste Elektrodenteil (31), der erste sich erstreckende Elektrodenteil (32) und die zweite Elektrode (4) aus verschiedenen Materialien hergestellt werden.

9. Kristalloszillator (200), der Folgendes aufweist:
ein schwingendes Substrat (2), das eine erste Oberfläche (21), eine zweite Oberfläche (22), die der genannten ersten Oberfläche (21) entgegengesetzt ist, und eine Seitenfläche (24), die die genannte erste Oberfläche (21) und die genannte zweite Oberfläche (22) miteinander verbindet, aufweist;
eine erste Elektrode (3), die einen ersten Elektrodenteil (31), der auf der genannten ersten Oberfläche (21) des genannten schwingenden Substrats (2) angeordnet ist, und einen ersten sich erstreckenden Elektrodenteil (32), der sich von dem genannten ersten Elektrodenteil (31) auf der genannten ersten Oberfläche (21) an der genannten Seitenfläche (24) entlang zu der genannten zweiten Oberfläche (22) erstreckt, beinhaltet;
eine zweite Elektrode (4), die auf der genannten zweiten Oberfläche (22) des genannten schwingenden Substrats (2) angeordnet ist und einen zweiten Elektrodenteil (41) und einen zweiten sich erstreckenden Elektrodenteil (42), der sich von dem genannten zweiten Elektrodenteil (41) in Richtung auf den genannten ersten sich erstreckenden Elektrodenteil (32) auf der genannten zweiten Oberfläche (22) erstreckt, beinhaltet, wobei ein Vorsprung des genannten zweiten Elektrodenteils (41) auf der genannten zweiten Oberfläche (22) des genannten schwingenden Substrats (2) einen Vorsprung des genannten ersten Elektrodenteils (31) auf der genannten zweiten Oberfläche (22) des genannten schwingenden Substrats (2) teilweise überlappt, wobei der genannten zweite sich erstreckende Elektrodenteil (42) und der genannte erste sich erstreckende Elektrodenteil (32) auf der gleichen Seite des genannten schwingenden Substrats (2) liegen, **gekennzeichnet durch**
einen tragenden Rahmen (5), der aus einem Fotolackmaterial hergestellt ist und auf der genannten zweiten Oberfläche (22) des genannten schwingenden Substrats (2) angeordnet ist, wobei der genannte tragende Rahmen (5) den genannten zweiten Elektrodenteil (41) umgibt, wobei zumindest ein Teil des genannten zweiten sich erstreckenden Elektrodenteils (42) außerhalb des genannten tragenden Rahmens (5) liegt.

10. Kristalloszillator (200) nach Anspruch 9, **dadurch gekennzeichnet, dass** der genannte tragende Rahmen (5) eine von 10 µm bis 100 µm reichende Dicke hat.

11. Kristalloszillator (200) nach Anspruch 9 oder 10, **dadurch gekennzeichnet, dass** die genannte zweite Oberfläche (22) des genannten schwingenden Substrats (2) wenigstens einen Randbereich (23) beinhaltet, der außerhalb des genannten tragenden Rahmens (5) liegt und von ihm freigelegt ist, wobei der genannte erste sich erstreckende Elektrodenteil (32) und der genannte zweite sich erstreckende Elektrodenteil (42) auf dem genannten wenigstens einen Randbereich (23) liegen.

12. Kristalloszillator (200) nach einem der Ansprüche 9 bis 11, **dadurch gekennzeichnet, dass** der genannte tragende Rahmen (5) als Ringstruktur gebildet ist, wobei der genannte zweite sich erstreckende Elektrodenteil (42) sich von dem genannten zweiten Elektrodenteil (41) erstreckt, durch eine zwischen dem genannten Rahmen (5) und dem genannten schwingenden Substrat (2) definierte Region verläuft und an dem genannten wenigstens einen Randbereich (23) endet.

## Revendications

1. Procédé de fabrication d'un oscillateur à quartz (200), comprenant les étapes de :
a) formation d'une première partie d'électrode (31) sur une surface d'un substrat piézoélectrique (20) afin d'obtenir un produit semi-fini (300)
b) amincissement du substrat piézoélectrique (20) du produit semi-fini (300) de manière à obtenir un substrat oscillant (2) le substrat oscillant présentant une première surface (21) sur laquelle est formée la première partie d'électrode (31) ;
c) formation d'une seconde électrode (4) sur une deuxième surface (22) du substrat oscillant (2) opposée à la première surface (21) la seconde électrode (4) comprenant une seconde partie d'électrode (41) en correspondance positionnelle avec la première partie d'électrode (31) et une seconde partie d'électrode prolongée (42) s'étendant vers l'extérieur à partir de la seconde partie d'électrode (41) et disposée sur une zone périphérique du substrat oscillant (2) ;
d) formation d'une première partie d'électrode prolongée (32) qui s'étend à partir de la première partie d'électrode (31) le long d'une surface latérale (24) du substrat oscillant (2) jusqu'à la deuxième surface (22) du substrat oscillant (2), la première partie d'électrode (31) et la première partie d'électrode prolongée(32) coopérant pour former une première électrode (3) ; **caractérisé par**
e) la formation d'un cadre de support (5) sur la deuxième surface (22) du substrat oscillant (2) le cadre de support (5) étant réalisé en un matériau de photorésist et entourant la seconde partie d'électrode (41), au moins une partie de la seconde partie d'électrode prolongée (42) étant située à l'extérieur du cadre de support (5).

2. Procédé selon la revendication 1, **caractérisé en outre par**, après l'étape a) et avant l'étape b), la fixation du produit semi-fini (3 0 0) sur un substrat temporaire (6) avec la première partie d'électrode (31) faisant face au substrat temporaire (6).

3. Procédé selon la revendication 2, **caractérisé en outre par**, après l'étape e), l'élimination du substrat temporaire (6) de la première partie d'électrode (31) sur la première surface (21) du substrat oscillant (2).

4. Procédé selon l'une quelconque des revendications 1 à 3, **caractérisé en ce que** le matériau de photorésist est l'un d'une photorésist positif et d'un photorésist négatif.

5. Procédé selon l'une quelconque des revendications 1 à 4, **caractérisé en ce que** chacune de la première partie d'l'électrode (31) et de la seconde électrode (4) est réalisée en un matériau conducteur, et les étapes a) et c) sont réalisées par l'un d'un processus de dépôt et d'un processus d'impression.

6. Procédé selon l'une quelconque des revendications 1 à 5, **caractérisé en ce que** la première partie d'électrode prolongée (32) est réalisée en un matériau conducteur, et l'étape d) est réalisée par l'un d'un processus d'impression et d'un processus de dépôt.

7. Procédé selon l'une quelconque des revendications 1 à 6, **caractérisé en ce que** chacune de la première partie d'électrode (31), de la première partie d'électrode prolongée (3 2) et de la seconde électrode (4) est réalisée indépendamment en or, argent, aluminium ou une combinaison de ceux-ci.

8. Procédé selon l'une quelconque des revendications 1 à 7, **caractérisé en ce que** la première partie d'électrode (31), la première partie d'électrode prolongée (32) et la seconde électrode (4) sont réalisées en des matériaux différents.

9. Oscillateur à quartz (200) comprenant :
un substrat oscillant (2) présentant une première surface (21), une deuxième surface (22) opposée à ladite première surface (21) et une surface latérale (24) reliant ladite première surface (21) et ladite deuxième surface (22),
une première électrode (3) comprenant une première partie d'électrode (31) disposée sur ladite première surface (21) dudit substrat oscillant (2) , et une première partie d'électrode prolongée (32) s'étendant à partir de ladite première partie d'électrode (31) sur ladite première surface (21) le long de ladite surface latérale (24) jusqu'à ladite deuxième surface (22) ;
une seconde électrode (4) disposée sur ladite deuxième surface (22) dudit substrat oscillant (2) et comprenant une seconde partie d'électrode (41) et une seconde partie d'électrode prolongée (42) s'étendant à partir de ladite seconde partie d'électrode (41) vers ladite première partie d'électrode prolongée (32) sur ladite deuxième surface (22), une saillie de ladite seconde partie d'électrode (41) sur ladite deuxième surface (22) dudit substrat oscillant (2) chevauchant partiellement une saillie de ladite première partie d'électrode (31) sur ladite deuxième surface (22) du substrat oscillant (2), ladite seconde partie d'électrode prolongée (42) et ladite première partie d'électrode prolongée (32) étant situées du même côté dudit substrat oscillant (2) ; **caractérisé par**
un cadre de support (5) réalisé en un matériau de photorésist et disposé sur ladite deuxième surface (22) dudit substrat oscillant (2), ledit cadre de support (5) entourant ladite seconde partie d'électrode (41), au moins une partie de ladite seconde partie d'électrode prolongée (42) étant située à l'extérieur dudit cadre de support (5).

10. Oscillateur à quartz (200) selon la revendication 9, **caractérisé en ce que** ledit cadre de support (5) a une épaisseur comprise entre 10 µm et 100 µm.

11. Oscillateur à quartz (200) selon la revendication 9 ou 10, **caractérisé en ce que** ladite deuxième surface (22) dudit substrat oscillant (2) comprend au moins une zone périphérique (23) située à l'extérieur et exposée à partir dudit cadre de support (5), ladite première partie d'électrode prolongée (32) et ladite deuxième partie d'électrode prolongée (42) étant situées sur ladite au moins une zone périphérique (23).

12. Oscillateur à quartz (200) selon l'une quelconque des revendications 9 à 11, **caractérisé en ce que** ledit cadre de support (5) est formé sous la forme d'une structure annulaire, ladite seconde partie d'électrode prolongée (42) s'étendant à partir de ladite seconde partie d'électrode (41), passant par une région définie entre ledit cadre de support (5) et ledit substrat oscillant (2), et se terminant au niveau de ladite au moins une zone périphérique (23).
